Europäisches Patentamt

European Patent Office

Office européen des brevets

(11) Publication number: 0 384 056
A1

# EUROPEAN PATENT APPLICATION

(21) Application number: 89301861.4

(22) Date of filing: 24.02.89

(51) Int. Cl.⁵: **H01L 31/052, F24J 2/20**

(43) Date of publication of application:
29.08.90 Bulletin 90/35

(84) Designated Contracting States:
AT BE CH DE ES FR GR IT LI LU NL SE

(71) Applicant: **THE OPEN UNIVERSITY**
P.O. Box 77 Walton Hall
Milton Keynes Buckinghamshire MK7
6BT(GB)

(72) Inventor: **Jones, Barrie William Energy and
Env. Res. Unit**
**The Open University Walton Hall**
**Milton Keynes Buckinghamshire, MK7
6BT(GB)**
Inventor: **Forrest, Robert John Energy & Env.
Res. Unit**
**The Open University Walton Hall**
**Milton Keynes Buckinghamshire,MK7
6BT(GB)**

(74) Representative: **Thomson, Roger Bruce et al
POLLAK MERCER & TENCH Eastcheap
House Central Approach
Letchworth Hertfordshire SG6 3DS(GB)**

(54) **Solar collectors.**

(57) A solar collector which converts solar radiation simultaneously into electrical and thermal energy, thus generating both electricity and heat, comprises a photovoltaic cell (10) and a thermal absorber (12) arranged to receive solar radiation not converted by the photovoltaic cell. Thermal enhancement means, for example heat transfer fluid passed through passages (16,18), increase s the operating temperature difference between the photovoltaic cell and the thermal absorber as compared with a solar collector in which such enhancement is absent or not operative. Preferably the thermal enhancement means functions to cool the photovoltaic cell (10).

FIG.1

## SOLAR COLLECTORS

This invention relates generally to solar collectors, and is particularly concerned with solar collectors which are able to collect solar radiation and convert that radiation simultaneously into electrical and thermal energy, thus generating both electricity and heat.

Conventionally, solar collectors have been designed and used to convert solar radiation either into electricity or into heat, and the two processes have heretofore generally been considered to be mutually exclusive. The efficiency of conversion of solar energy to electrical energy using photovoltaic cells is limited by a large number of factors. The two most important factors are firstly that conversion efficiency falls as the temperature of the photovoltaic cell rises, and secondly that the photovoltaic cell is only responsive to a limited part of the solar electromagnetic spectrum.

The efficiency of conversion of solar radiation to thermal energy is less adversely affected by considerations of the solar electromagnetic spectrum, as thermal absorbers are usually spectrally irresponsive over most of the solar spectrum.

It is therefore to be expected that combining a photovoltaic cell with a thermal absorber would result in the photovoltaic cell operating at a higher temperature than normal, and therefore with decreased efficiency.

It is an object of the present invention to provide a solar collector which can convert solar radiation both into electrical and thermal energy in such a way that the two processes are compatible.

It is a further object of the invention to provide a solar collector which is a hybrid of a photovoltaic device and a thermal absorber and which will operate in a manner to produce both electrical energy and thermal energy with efficiency for both processes.

Broadly in accordance with the present invention there is provided a solar collector comprising a photovoltaic device arranged to be exposed to solar radiation, thermal absorber means arranged to receive solar radiation not converted by said photovoltaic device, and thermal enhancement means arranged to increase the operating temperature difference as between the photovoltaic device and the thermal absorber means as compared with a collector in which such thermal enhancement means is absent or not operative.

Preferably, the thermal enhancement means functions to cool the photovoltaic device.

The thermal enhancement means may take any one of a number of different forms within the scope of the present invention. For example, the thermal enhancement means may comprise means for passing a heat transfer fluid over or past one or other or both of the photovoltaic device and thermal absorber means. Alternatively, the thermal enhancement means may comprise a chamber which serves as a thermal insulating chamber. Such a chamber may be filled with air or be partially or wholly evacuated.

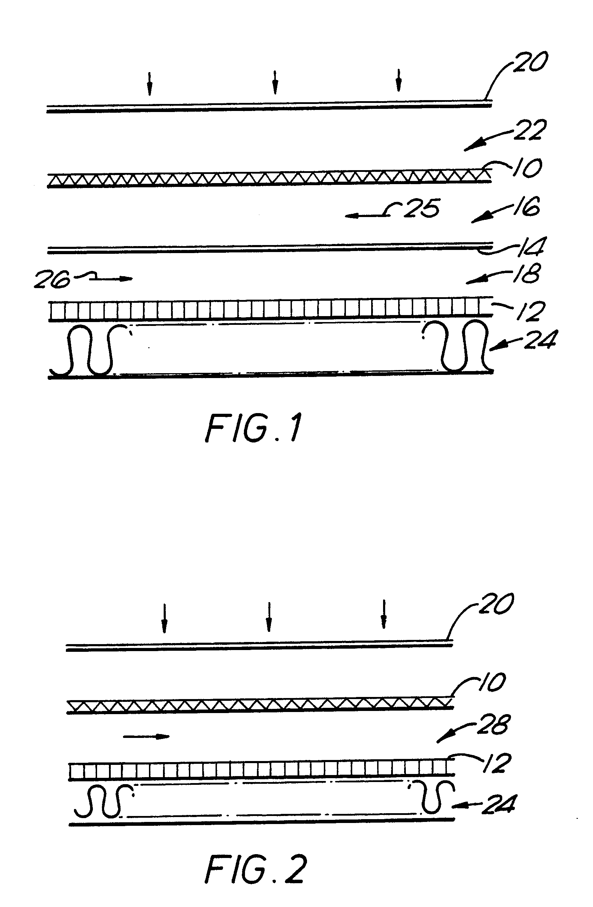

In order that the invention may be more fully understood, a number of presently preferred embodiments of solar collector in accordance with the invention will now be described by way of example and with reference to the accompanying drawings in which Figures 1 to 5 are schematic sectional views through five different embodiments of solar collector in accordance with the invention.

In the respective Figures of the drawings those elements of the collector which are common to the several views are indicated by the same respective reference numerals.

Referring first to Fig. 1, this shows a solar collector comprising a photovoltaic cell 10 which is positioned above a thermal absorber 12. Between the photovoltaic cell 10 and the thermal absorber 12 is positioned a transparent sheet 14 which thus defines upper and lower ducts or passageways 16 and 18 respectively. The transparent sheet 14 may have thermal insulating properties in order to provide a thermal barrier between the upper and lower passages 16 and 18. A transparent cover 20 is positioned above the photovoltaic cell 10, thus defining an air space 22 therebetween. This air space 22 helps to reduce energy losses from the top of the solar collector. The components of the solar collector are housed within a thermally insulating container, part of which is indicated at 24 below the thermal absorber 12. This insulating container reduces heat loss to the ambient atmosphere.

The photovoltaic cell 10 has rear electrodes (not shown) which permit the solar radiation which is not absorbed and converted to electricity in the cell to pass through the cell and thereafter be incident on the thermal absorber 12. This can be achieved for example by means of semi-transparent rear electrodes for the photovoltaic cell or by providing it with metallic gridded rear contacts which do not cover the full surface area of the cell.

In operation, solar radiation which falls upon the solar collector is first incident upon the photovoltaic cell 10. This cell absorbs radiation within a certain portion of the electromagnetic spectrum, the particular portion depending upon the type of cell. The remaining solar radiation which is not absorbed or reflected by the cell passes through the cell and through the transparent sheet 14 to be incident on the thermal absorber 12.

This causes the thermal absorber to rise in temperature. In order that the solar collector shall operate efficiently both in terms of the photovoltaic cell providing electricity and the thermal absorber providing heat, fluid is passed through the upper and lower passages 16 and 18 as indicated by the arrows 25 and 26. The fluid, whether gas or liquid, is first passed through the upper passage 16 and then back through the lower passage 18. In the case of an air-heating system the fluid is air drawn from the atmosphere and passed first through the upper passage 16. In the case of a water heating system the fluid passed through the upper passage 16 is preferably water drawn from a cold water tank. In each case, as the fluid passing through the upper passage 16 is cool with respect to the photovoltaic cell 10 which has been heated by the solar radiation, it has the effect of actively cooling the photovoltaic cell and thus allowing it to operate at a higher conversion efficiency. The returning fluid in the lower passage 18 is in contact with the surface of the thermal absorber 12 and is heated thereby, thus enabling heat to be transferred to the fluid and thence to a point of utilisation.

The transparent plate 14 is preferably a thermal insulating plate which insulates the fluid in the upper passage 16 from that in the lower passage 18. This effectively prevents the hotter fluid in the lower passage 18 from heating the fluid in the upper passage 16 and hence the photovoltaic cell 10. By making the transparent plate 14 of thermally insulating material this also ensures that thermal losses from radiation, convection and conduction to the exterior are minimised.

Referring now to Fig. 2, in this embodiment the transparent plate or sheet which separates the upper and lower passages 16 and 18 in Fig. 1 is omitted, resulting in just one fluid duct 28 between the photovoltaic cell 10 and the thermal absorber 12. Even without the separating plate or sheet the passage of fluid between the cell and the thermal absorber enhances the operating temperature difference between the photovoltaic device and the thermal absorber inter alia by its cooling effect on the former.

In an alternative embodiment which is not shown in the drawings and which is a variation of the embodiment shown in Fig. 1, flow of fluid through the upper passage 16 may be omitted, leaving just an air space between the photovoltaic cell 10 and the intermediate sheet or plate 14. In this case the intermediate element 14 can be a thin membrane and need not be thermally insulating.

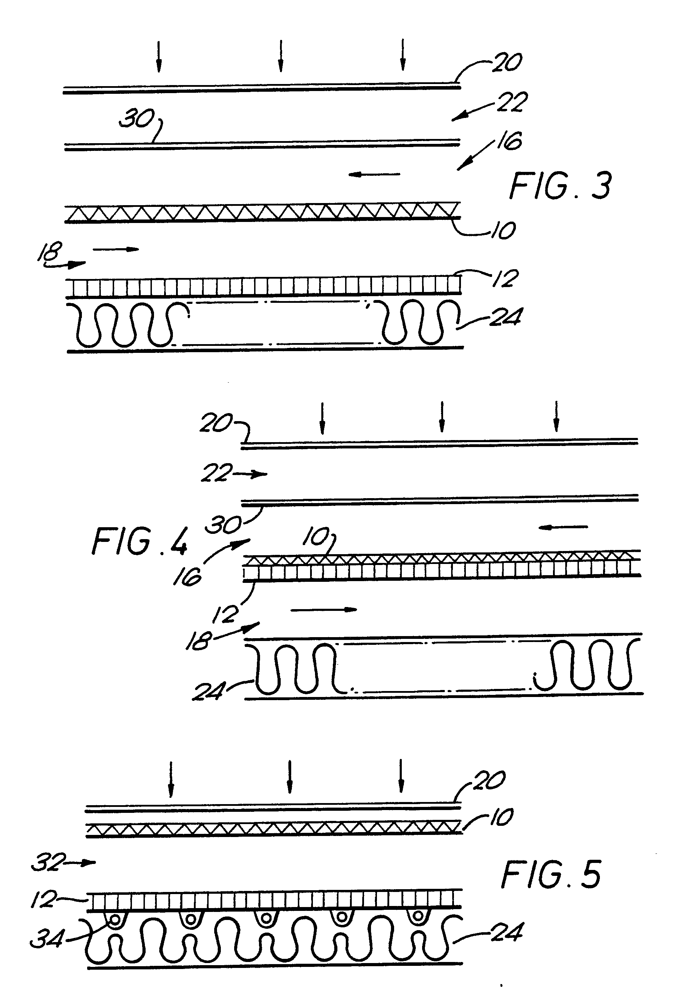

Referring now to Fig. 3, in this embodiment, in contrast to Fig. 1, the photovoltaic cell 10 is positioned between the upper and lower fluid passages 16 and 18, so that the heat transfer fluid flows first above the photovoltaic cell 10 and then below it and in contact with the thermal absorber 12. In this embodiment a transparent plate or sheet 30 is provided between the photovoltaic cell 10 and the top cover 20 in order to define the upper fluid passage 16 and also to define the air gap 22.

The embodiment shown in Fig. 4 is a variation of the solar collector shown in Fig. 3, where the thermal absorber 12 is now positioned closely adjacent to or in contact with the photovoltaic cell 10. In this embodiment the fluid flow in the upper passage 16 is in thermal contact with the photovoltaic cell 10, and the fluid in the lower passage 18 is in thermal contact with the thermal absorber 12. The cell 10 and thermal absorber 12 may or may not be in thermal contact with each other.

Fig. 5 shows yet another variation where the photovoltaic cell 10 and the thermal absorber 12 are separated by an evacuated chamber 32. In this embodiment the heat is extracted from the thermal absorber 12 by a series of pipes or ducts 34 running beneath the thermal absorber and insulated by the insulating material 24 which surrounds the solar collector. In a further variation of this embodiment, a further evacuated chamber may replace the thermal insulating material 24.

In those embodiments where there is fluid flow through upper and lower passages, ducts or chambers, the fluid flow may be first through the upper passage and then through the lower passage, or vice versa, provided that the effect of the fluid flow is to enhance the operating temperature differential between the photovoltaic cell and the thermal absorber in the sense to keep the photovoltaic cell cooler than would otherwise be the case.

In each of the embodiments the top cover 20 may be omitted, or may be supplemented by additional cover sheets or plates in order to suppress or reduce thermal losses from the top of the solar collector.

## Claims

1. A solar collector comprising a photovoltaic device (10) arranged to be exposed to solar radiation, and thermal absorber means (12) arranged to receive solar radiation not converted by said photovoltaic device, characterised by thermal enhancement means arranged to increase the operating temperature difference between the photovoltaic device (10) and the thermal absorber means (12) as compared with a collector in which said thermal enhancement means is absent or not operative.

2. A solar collector according to claim 1, characterised in that the thermal enhancement means functions to cool the photovoltaic device (10).

3. A solar collector according to claim 1 or 2, characterised in that the thermal enhancement means comprises means (16,18;28) to pass a heat transfer fluid over or past one or other or both of the photovoltaic device (10) and the thermal absorber means (12).

4. A solar collector according to claim 1 or 2, characterised in that the thermal enhancement means comprises a chamber (32) which serves as a thermal insulating chamber.

5. A solar collector according to claim 4, characterised in that said chamber (32) is partially or wholly evacuated.

6. A solar collector according to any preceding claim, characterised by a thermally insulating sheet (14) positioned between the photovoltaic device (10) and the thermal absorber means (12).

7. A solar collector according to any preceding claim, characterised by a transparent cover (20) positioned spaced above the photovoltaic device (10) to define an air space (22) therebetween.

8. A solar collector according to any of claims 1 to 3, characterised by a plate-like photovoltaic device (10), a transparent cover (20) spaced above the photovoltaic device to define an air space (22) therebetween, a plate-like thermal absorber (12) spaced below the photovoltaic device, a thermally insulating member (14) between the photovoltaic device and the thermal absorber to define upper and lower passageways (16,18), and means to cause a heat transfer fluid to be circulated first through said upper passageway (16) and thereafter through said lower passageway(18).

9. A solar collector according to any of claims 1 to 3, characterised by a plate-like photovoltaic device (10), a transparent cover (20) spaced above the photovoltaic device, a transparent divider (30) between the photovoltaic device and said cover to define an air space (22) above the divider and a first passageway (16) below the divider, a plate-like absorber (12) spaced below the photovoltaic device to define a second passageway (18) therebetween, and means to cause a heat transfer fluid to be circulated successively through said first and second passageways (16,18).

10. A solar collector according to any of claims 1 to 3, characterised by a plate-like photovoltaic device (10) in contact with or closely adjacent to a plate-like thermal absorber (12), the photovoltaic device being above the thermal absorber, a transparent cover (20) spaced above the photovoltaic device (10), and means defining first and second passageways (16,18) for a heat transfer fluid respectively above the photovoltaic device (10) and below the thermal absorber (12).

11. A solar collector according to any of claims 1 to 3, characterised by a plate-like photovoltaic device (10), a transparent cover (20) above the photovoltaic device, a plate-like thermal absorber (12) spaced below the photovoltaic device with an evacuated chamber (32) therebetween, and means (34) positioned immediately below the thermal absorber (12) to extract heat from the thermal absorber.

12. A solar collector according to any preceding claim, characterised in that the photovoltaic device (10) has semi-transparent electrodes on the underside thereof.

13. A solar collector according to any of claims 1 to 11, characterised in that the photovoltaic device (10) has a grid of metallic electrodes on the underside thereof.

FIG.1

FIG.2

*FIG. 3*

*FIG. 4*

*FIG. 5*

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 444 992 (COX, III) * Column 4, line 12 - column 5, line 20; figures 1-4 * | 1-3,7, 13 | H 01 L 31/052 F 24 J 2/20 |
| Y | | 12 | |
| Y | EP-A-0 217 405 (HOSIDEN ELECTRONICS CO. LTD) * Abstract; figure 3 * | 12 | |
| X | US-A-4 186 033 (BOLING et al.) * Column 5, lines 32-49; column 5, line 60 - column 6, line 19; column 6, lines 32-53; figures 3,5,6 * | 1-3,7 | |
| A | | 8,9 | |
| X | DE-A-3 109 284 (INTERATOM INTERNATIONALE ATOMREAKTORBAU GmbH) * Page 11, line 8 - page 12, line 11; figures 2,3 * | 1-5 | |
| A | | 6,11 | TECHNICAL FIELDS SEARCHED (Int. Cl.5) |
| X | US-A-4 081 289 (CAMPBELL, III) * Column 2, line 57 - column 3, line 25; column 3, lines 47-68; figures 1-3 * | 1-3,10 | F 24 J H 01 L |
| X | FR-A-2 415 178 (KORZDORFER) * Page 8, lines 10-19; page 9, lines 18-30; page 13, line 32 - page 14, line 28; figures 5,6,18,19 * | 1-3 | |
| A | EP-A-0 109 344 (SYNOPSIS) * Page 5, line 8 - page 6, line 6; page 10, lines 5-19; figures 3,6,7 * -/- | 1,9 | |

The present search report has been drawn up for all claims

| Place of search | Date of completion of the search | Examiner |
|---|---|---|
| THE HAGUE | 09-10-1989 | BELTZUNG F.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................

& : member of the same patent family, corresponding document

EPO FORM 1503 03.82 (P0401)

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DE-A-2 833 241  (FRANZ)<br>* Page 5, line 22 - page 6, line 8;<br>page 6, line 28 - page 7, line 4;<br>figures * | 1,8 | |
| A | EP-A-0 057 486  (STICHTING BOUWCENTRUM)<br>* Page 7, lines 6-28; page 8, lines<br>12-22; figures 3,6 * | 1 | |

TECHNICAL FIELDS
SEARCHED (Int. Cl.5)

The present search report has been drawn up for all claims

| Place of search | Date of completion of the search | Examiner |
|---|---|---|
| THE HAGUE | 09-10-1989 | BELTZUNG F.C. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P0401)